(19) Europäisches Patentamt
European Patent Office
Office européen des brevets

(11) **EP 2 336 387 B1**

(12) **EUROPÄISCHE PATENTSCHRIFT**

(45) Veröffentlichungstag und Bekanntmachung des Hinweises auf die Patenterteilung:
**04.09.2013  Patentblatt 2013/36**

(51) Int Cl.:
*C23C 14/50* (2006.01)          *C23C 16/458* (2006.01)
*F16H 21/14* (2006.01)

(21) Anmeldenummer: **11405237.6**

(22) Anmeldetag: **08.10.2007**

(54) **Werkstückträgereinrichtung**

Workpiece mount device

Dispositif de porte-pièce

(84) Benannte Vertragsstaaten:
**AT BE BG CH CY CZ DE DK EE ES FI FR GB GR HU IE IS IT LI LT LU LV MC MT NL PL PT RO SE SI SK TR**

(43) Veröffentlichungstag der Anmeldung:
**22.06.2011  Patentblatt 2011/25**

(62) Dokumentnummer(n) der früheren Anmeldung(en) nach Art. 76 EPÜ:
**07405302.6 / 2 048 263**

(73) Patentinhaber: **Oerlikon Trading AG, Trübbach**
**9477 Trübbach (CH)**

(72) Erfinder:
• **Esser. Stefan**
  **52072 Aachen (DE)**
• **Zäch, Martin**
  **9496 Balzers (LI)**

(74) Vertreter: **Wagner, Wolfgang Heribert et al**
**Wagner Patent AG**
**Apollostrasse 2**
**Postfach 1021**
**8032 Zürich (CH)**

(56) Entgegenhaltungen:
**WO-A-2007/025397**

## Beschreibung

## Technisches Gebiet

Die Erfindung betrifft eine Werkstückträgereinrichtung gemäss dem Oberbegriff des Anspruchs 1. Derartige Einrichtungen werden zur Bearbeitung von Werkstücken vor allem in Vakuumanlagen, insbesondere zur Beschichtung derselben verwendet.

## Stand der Technik

Aus WO 2007/025 397 A1 ist eine gattungsgemässe Werkstückträgereinrichtung bekannt, bei der das Uebertragerteil als exzentrisch mit einer Drehachse verbundene Antriebsscheibe ausgebildet ist, welche von einer entsprechenden Ausnehmung am Uebertragerteil knapp umgeben ist. Eine Beeinflussung des Uebersetzungsverhältnisses zwischen der Drehung der Werkstücke und der des Drehgestells ist nur über ein Vorgelegegetriebe möglich, das direkt die Bewegung der Antriebsscheibe steuert.

Eine weitere Werkstückträgereinrichtung ist aus EP 1 153 155 A1 bekannt. Hier werden die an Drehgestellen drehbar gelagerten Werkstückhalter gedreht, indem jeweils ein Zahnrad am Werkstückhalter mit einem die Antriebsachse des Drehgestells koaxial umgebenden Zahnkranz eingreift, der dem Grundgestell gegenüber unverdrehbar ist. Diese bekannte Werkstückträgereinrichtung ist verhältnismässig komplex aufgebaut. Das Uebersetzungsverhältnis ist nur innerhalb ziemlich enger Grenzen wählbar.

Bei einer der aus der DE 198 03 278 A1 ersichtlichen Werkstückträgereinrichtungen wird die Drehung der Werkstückhalter durch am Grundgestell verankerte Mitnehmer bewirkt, die mit denselben vorübergehend eingreifen. In diesem Fall ist die Drehung intermittierend, was an sich meist nachteilig ist und, vor allem wenn eine Beschichtung aus mehreren sehr dünnen Lagen angelegt wird, die Qualität der Werkstücke beeinträchtigen kann.

DE 103 08 471 A1 zeigt eine Werkstückträgereinrichtung, bei welcher Werkstückträger in mehreren konzentrischen Ringen auf einem Drehgestell angeordnet sind. Durch ein mit einem stillstehenden Zentralrad eingreifendes Zwischengetriebe auf dem Drehgestell wird jeweils ein Werkstückträger eines Ringes in Drehung versetzt. Die zu einem Ring gehörigen Werkstückträger sind so miteinander wirkverbunden, dass sich diese Drehung auf die übrigen Werkstückträger überträgt.

## Darstellung der Erfindung

Der Erfindung liegt die Aufgabe zu Grunde, eine gattungsgemässe Werkstückträgereinrichtung anzugeben, die einfach im Aufbau und zuverlässig ist und die Möglichkeit bietet, auf einfache Weise das Uebersetzungsverhältnis einzustellen. Diese Aufgabe wird durch die Merkmale im Kennzeichen des Anspruchs 1 gelöst.

Die durch die Erfindung erzielten Vorteile liegen vor allem darin, dass der Antrieb der Werkstückhalter sehr einfach ist und dennoch eine Wahl des Uebersetzungsverhältnisses aus einem verhältnismässig weiten Bereich zulässt.

## Kurze Beschreibung der Zeichnungen

Im folgenden wird die Erfindung anhand von Figuren, welche lediglich Ausführungsbeispiele darstellen, näher erläutert.

Es zeigen

Fig. 1    schematisch einen axialen Schnitt durch eine erfindungsgemässe Werkstückträgereinrichtung gemäss einer ersten Ausführungsform,

Fig. 2    einen Ausschnitt aus Fig. 1,

Fig. 3    eine Draufsicht auf den Ausschnitt gemäss Fig. 2,

Fig. 4    teilweise geschnitten einen Teil der erfindungsgemässen Werkstückträgereinrichtung in perspektivischer Darstellung und

Fig. 5    vergrössert eine Draufsicht auf einen Teil der erfindungsgemässen Werkstückträgereinrichtung.

## Wege zur Ausführung der Erfindung

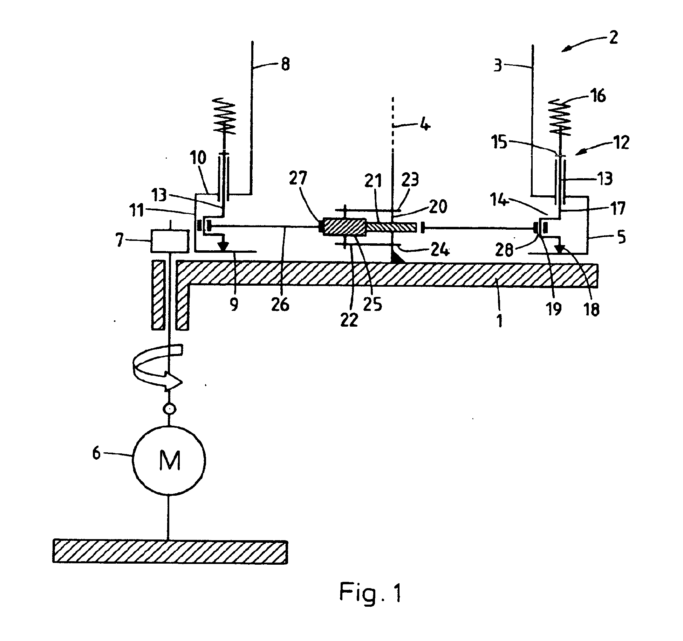

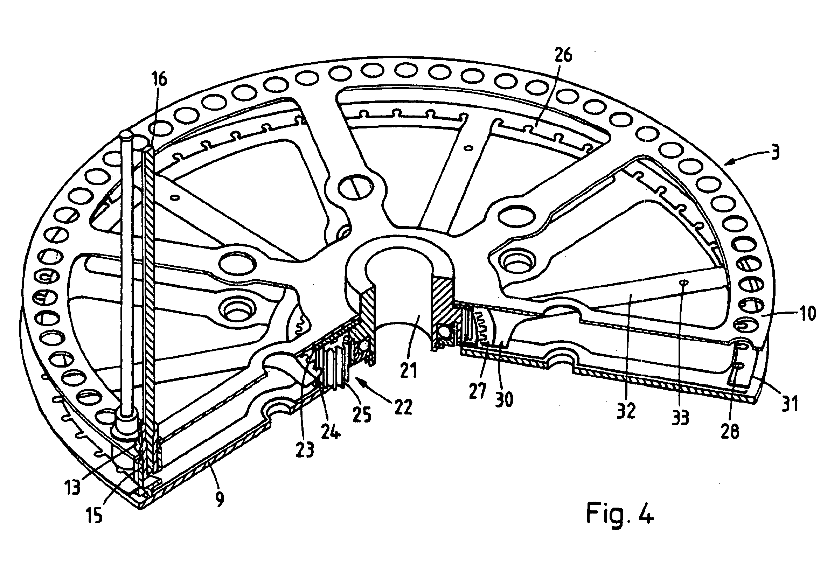

Gemäss einer bevorzugten Ausführungsform einer erfindungsgemässen Werkstückträgereinrichtung ist (Fig. 1) auf einem feststehenden Grundgestell 1 ein Werkstückträger 2 angeordnet mit einem Drehgestell 3, das um eine senkrechte Antriebsachse 4 drehbar am Grundgestell 1 gelagert ist und am unteren Ende an seiner Aussenseite einen Zahnkranz 5 trägt, mit welchem ein von einem Motor 6 angetriebenes Zahnrad 7 eingreift. Das Drehgestell 3 ist als um die Antriebsachse 4 annähernd rotationssymmetrisches geschlossenes Gehäuse ausgebildet mit zentralen Rohrabschnitten 8, zwischen denen längs der Antriebsachse 4 aufeinanderfolgende Auskragungen liegen (in Fig. 1 ist nur die unterste dargestellt, s. auch Fig. 4), welche jeweils von einem Boden 9, einem Deckel 10 und einem zu den Rohrabschnitten 8 konzentrischen Aussenring 11 gebildet werden, der an den Aussenrand des Bodens 9 anschliesst und den Aussenrand des Deckels 10 etwas überragt.

Das Drehgestell 3 trägt an jeder der besagten Auskragungen eine Gruppe 12 von Werkstückhaltern 13, die jeweils auf gleicher Höhe gleichmässig über einen die Antriebsachse 4 umgebenden Kreis verteilt sind. Jeder Werkstückhalter 13 ist um eine zur Antriebsachse 4 parallele Halterachse drehbar und umfasst eine Basis 14, die z.T. innerhalb einer Auskragung des Drehgestells 3 liegt und eine Halterung 15 zur Befestigung eines Werkstücks 16, welche mit der Basis 14 über einen durch den Deckel 10 durchgeführten Achsstift 17 verbunden ist. Weiter umfasst die Basis 14 einen Lagerstift 18 mit einer nach unten weisenden kegelförmigen Spitze, dessen Achse wie beim Achsstift 17 mit der Halterachse zusammenfällt und im Boden 9, wo die Spitze in eine entsprechende Ausnehmung eingreift, drehbar gelagert ist. Der Lagerstift 18 und der Achsstift 17 sind jeweils durch einen kurbelartigen Zwischenabschnitt verbunden, welcher einen zur Halterachse parallelen, aber von ihr beabstandeten Antriebsstift 19 umfasst. Die Basis 14 ist ein einfaches Biegeteil von im wesentlichen gleichbleibendem Querschnitt. Die aufgesteckte Halterung 15 weist eine oben offene zylindrische Ausnehmung auf, in welche das Werkstück 16, z.B. ein Fräskopf, eingesteckt ist.

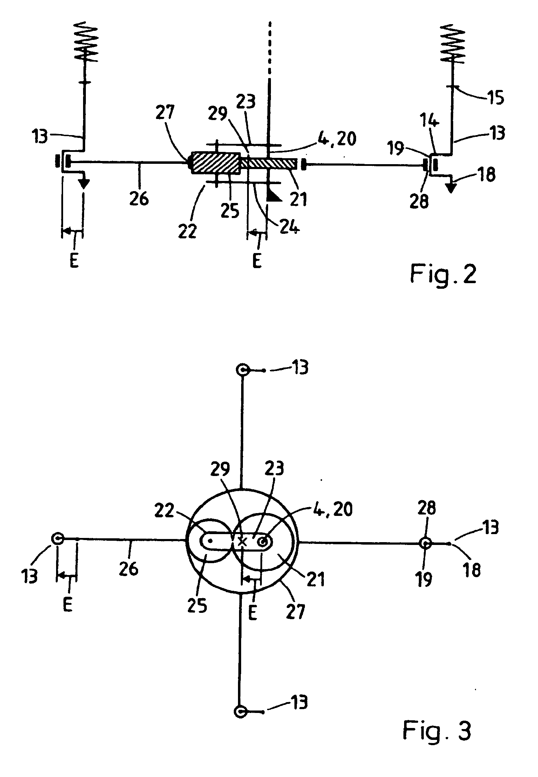

Eine am Grundgestell 1 drehfest verankerte Welle 20 trägt auf der Höhe jeder der Gruppen 12 ein gegenüber dem Grundgestell 1 unverdrehbares Zentralrad 21 (s. a. Fig. 2, 3) mit einer Aussenverzahnung. Jeweils auf gleicher Höhe ist ein Antriebsteil 22 angeordnet, welches eine um die Antriebsachse 4 drehbare Halterung mit einem oberhalb des Zentralrades 21 liegenden oberen Arm 23 und einem gleichartigen unterhalb des Zentralrades 21 liegenden unteren Arm 24 umfasst sowie ein an der Halterung angebrachtes Zwischengetriebe, das im Beispiel lediglich aus einem zwischen dem oberen Arm 23 und dem unteren Arm 24 gelagerten Ritzel 25 besteht, das um eine zur Antriebsachse 4 parallele Ritzelachse drehbar ist und dessen Verzahnung mit der des Zentralrades 21 eingreift.

Das Ritzel 25 ist mit den Antriebsstiften 19 der auf der Höhe des Zentralrades 21 und des Antriebsteils 22 liegenden Gruppe 12 von Werkstückträgern 13 durch ein Uebertragerteil 26 verbunden, das eine kreisförmige zentrale Kopplungsausnehmung aufweist. Ihr Rand trägt einen nach innen weisenden Zahnkranz 27, welcher mit der Verzahnung des Ritzels 25 eingreift. Weiter aussen weist das Uebertragerteil 26 für jeden Werkstückhalter 13 eine Antriebsöffnung 28 auf, durch welche dessen Antriebsstift 19, von ihrem Rand knapp umgeben, ragt. Das Uebertragerteil 26 ist also mit den Werkstückhaltern 13 jeweils drehbar, aber im übrigen mit geringem Spiel verbunden und steht mit dem Antriebsteil 22, genauer dem Ritzel 25 desselben, im Eingriff.

Der Mittelpunkt des Zahnkranzes 27 am Uebertragerteil 26 bildet einen Abtriebspunkt 29, der von der Antriebsachse 4 um eine Exzentrizität E beabstandet ist. Der Abstand des Antriebsstiftes 19 eines jeden Werkstückhalters 13 von der jeweiligen Halterachse entspricht ebenfalls der Exzentrizität E.

Das Uebertragerteil 26, das in Fig. 2, 3 nur schematisch dargestellt ist, kann (s. Fig. 4, wo eine Auskragung dargestellt ist, aber dabei Teile des Gehäuses, die meisten Werkstückträger 13 und die Welle 20 weggelassen sind) als ebenes Stanzteil ausgebildet sein mit einem Innenring 30, der die besagte Kopplungsausnehmung umgibt und einem Aussenring 31, in dem die in diesem Fall sechsundsechzig Antriebsöffnungen 29 für den Eingriff mit ebensovielen Werkstückträgern 13 über den Umfang verteilt angebracht sind. Der Innenring 30 und der Aussenring 31 sind durch radiale Speichen 32 verbunden, welche, im Beispiel durch Löcher 33, geschwächt sind, sodass sie Sollbruchstellen bilden, die im Fall einer Blockierung eines der Werkstückhalter 13 der entsprechenden Gruppe 12 brechen.

Wird das Drehgestell 3 durch den Motor 6 um die Antriebsachse 4 gedreht, so wird über die mit dem Drehgestell 3 verbundenen Werkstückträger 13 das mit denselben eingreifende Uebertragerteil 26 mitgenommen. Da die Verzahnung des Ritzels 25 mit dem Zahnkranz 27 eingreift, wird dasselbe auch in Drehung versetzt und läuft auf dem Zentralrad 21 ab, wodurch das Antriebsteil 22 gegenüber dem Uebertragerteil 26 verdreht wird und eine Exzenterbewegung desselben bewirkt, bei welcher der die Drehachse 4 mit dem Abtriebspunkt 29 verbindende Vektor, dessen Länge der Exzentrizität E entspricht, um die Drehachse 4 umläuft. Die Exzenterbewegung überträgt sich auf die Antriebsstifte 19, sodass jeder Umlauf der Exzenterbewegung eine Umdrehung der Werkstückträger 13 bewirkt, wobei jeweils der von der Halterachse zum entsprechenden Antriebsstift 19 weisende Vektor jederzeit zum obengenannten Vektor parallel ist.

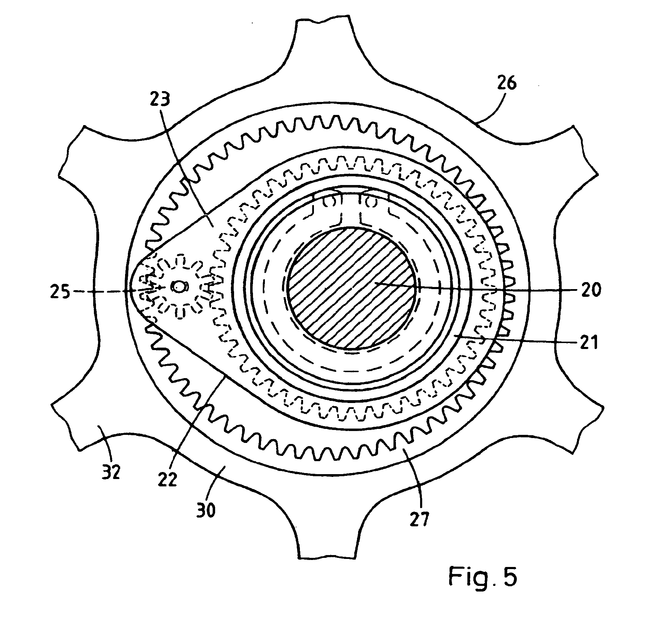

Betrachtet man die Bewegungen des Uebertragerteils 26 und des Antriebsteils 22 in einem am Grundgestell 1 festgemachten Koordinatensystem (s. dazu Fig. 3, 5, in letzterer ist der Deckel 10 weggelassen) und bezeichnet man die Zahnzahl der Zentralverzahnung, d.h. der Verzahnung des Zentralrades 21 mit $Z_z$ und diejenige der Uebertragerverzahnung, d.h. der Verzahnung des Zahnkranzes 27 mit $Z_u$, so ergibt sich bei einer Umdrehung des Antriebsteils 22 um die Antriebsachse 4 im Uhrzeigersinn, entsprechend einem Umlauf bei der Exzenterbewegung des Uebertragerteils 26, d.h. $U_u=1$, eine Drehung $\overline{U_D}$ desselben und damit des Drehgestells 3 von

$$(1) \quad U_D = 1 + Z_z/Z_U$$

Umdrehungen im Uhrzeigersinn. Mit $z=Z_z/Z_U$ gilt also

$$(1') \quad U_D:U_U = 1+z$$

Dies ergibt sich daraus, dass das Uebertragerteil 26 einerseits mitdreht, d.h. ebenfalls eine volle Umdrehung im Uhrzeigersinn ausführt und andererseits zusätzlich durch das auf dem Zentralrad 21 ablaufende Ritzel 25 um z Umdrehungen gedreht wird. Auf 1+z Umdrehungen des Drehgestells 3 kommt also eine Umdrehung des Antriebsteils 22. Damit ergibt sich für das Uebersetzungsverhältnis, d.h. den Quotienten zwischen der Drehrate des Antriebsteils 22 und damit der Exzenterbewegung des Uebertragerteils 26 einerseits und der Drehrate des Drehgestells 3 andererseits

$$(2) \quad u = \frac{U_U}{U_D} = \frac{1}{1+z}$$

Gilt also z.B. wie beim Ausführungsbeispiel gemäss Fig. 4, 5 $Z_Z$=46 und $Z_U$=60, so ergibt sich z zu ca. 0,77 und u zu ca. 0,57. Gegenüber dem Drehgestell 3 läuft die Exzenterbewegung rückwärts. Das Verhältnis der Drehraten beträgt u-1, also im Beispiel ca. -0,43.

Das Uebersetzungsverhältnis hängt nur von z ab und kann z.B. durch Auswechseln der Welle 20 mit den Zentralrädern 21 und den Antriebsteilen 22 leicht geändert werden. So kann etwa eine andere Welle mit kleineren Zentralrädern eingesetzt und damit z verkleinert und das Uebersetzungsverhältnis u entsprechend (2) vergrössert werden. Der Eingriff mit dem Zahnkranz des Uebertragerteils verlangt dann grössere Ritzel, welche aber das Uebersetzungsverhältnis u nicht beeinflussen. Falls nötig können zusätzlich die Uebertragerteile ausgewechselt werden, doch ist dies aufwendiger.

Es ist jedoch leicht möglich, statt eines Ritzels ein komplexeres Zwischengetriebe mit mehreren an der Halterung des Antriebsteils gelagerten, miteinander in Wirkverbindung stehenden Zahnrädern, von denen eines mit der Zentralverzahnung und eines mit der Uebertragerverzahnung eingreift, einzusetzen. Das Uebersetzungsverhältnis u kann für verschiedene Gruppen von Werkstückträgern auch unterschiedlich eingestellt werden, indem eine Welle mit unterschiedlichen Zwischengetrieben und/oder Zentralrädern verwendet wird.

Die Ausbildung des geschilderten Ausführungsbeispiels kann auch in anderer Weise abgewandelt werden, ohne dass das Gebiet der Erfindung verlassen würde. So braucht die Zentralverzahnung nicht drehfest mit dem Grundgestell verbunden sein. Es ist z.B. möglich, die die Zentralräder tragende Welle über ein von der Bewegung des Drehgestells angetriebenes Vorgelegegetriebe mit dem Grundgestell zu verbinden, sodass die Zentralverzahnung jeweils eine Drehbewegung ausführt. Ein solches Vorgelegegetriebe kann etwa wie in WO 2007/025 397 A1 beschrieben ausgeführt und eingebaut sein. Auch in diesem Fall kann das Uebersetzungsverhältnis leicht durch Auswechseln der Welle mit den Zentralrädern und Antriebsteilen wie oben beschrieben geändert werden. Eine Ausführung, wie sie in der genannten Schrift in Fig. 10 dargestellt ist, bei der mehrere dem im Zusammenhang mit dem Ausführungsbeispiel beschriebenen entsprechende Werkstückträger um eine Hauptachse herum angeordnet sind, um die das Grundgestell durch einen Motor drehbar ist, während die Zahnkränze ihrer Drehgestelle mit einem ortsfesten Zahnrad eingreifen, ist ebenfalls möglich.

**Bezugszeichenliste**

| 1 | Grundgestell |
|---|---|
| 2 | Werkstückträger |
| 3 | Drehgestell |
| 4 | Antriebsachse |
| 5 | Zahnkranz |
| 6 | Motor |
| 7 | Zahnrad |
| 8 | Rohrabschnitt |
| 9 | Boden |
| 10 | Deckel |
| 11 | Aussenring |
| 12 | Gruppe |
| 13 | Werkstückhalter |
| 14 | Basis |
| 15 | Halterung |
| 16 | Werkstück |
| 17 | Achsstift |
| 18 | Lagerstift |
| 19 | Antriebsstift |
| 20 | Welle |
| 21 | Zentralrad |
| 22 | Antriebsteil |
| 23 | oberer Arm |
| 24 | unterer Arm |
| 25 | Ritzel |
| 26 | Uebertragerteil |
| 27 | Zahnkranz |
| 28 | Antriebsöffnung |
| 29 | Abtriebspunkt |
| 30 | Innenring |
| 31 | Aussenring |
| 32 | Speiche |
| 33 | Loch |

**Patentansprüche**

1. Werkstückträgereinrichtung mit mindestens einem Werkstückträger (2), mit einer eine Antriebsachse (4) umgebenden Welle (20) und einem um die Antriebsachse (4) drehbar an einem Grundgestell (1) gelagerten Drehgestell (3) und mit am Drehgestell (3) um Halterachsen drehbar gelagerten Werkstückhaltern (13), wobei der mindestens eine Werkstückträger (2) ein Antriebsteil (22) mit einer um die Antriebsachse (4) drehbar gelagerten Halterung sowie einen mit den drehbar gelagerten Werkstückhaltern (13) wirkverbundenen Übertragerteil (26) umfasst, **dadurch gekennzeichnet, dass** an der drehbar gelagerten Halterung ein Zwischengetriebe angebracht ist, welches mit der Welle (20) und dem Übertragerteil (26) jeweils wirkverbunden ist dergestalt, dass das Uebertragerteil (26) mit dem Antriebsteil (22) um einen von der Antriebsachse (4) um eine Exzentrizität (E) beabstandeten Abtriebspunkt (29) drehbar eingreift.

**2.** Werkstückträgereinrichtung nach Anspruch 1, **dadurch gekennzeichnet, dass** das Uebertragerteil (26) zur Drehung der Werkstückhalter (13) gegenüber dem Drehgestell (3) ausserdem mit mindestens zwei Werkstückhaltern (13) um einen um eine gleiche Exzentrizität (E) von der Halterachse beabstandeten Antriebspunkt drehbar eingreift.

## Claims

**1.** Workpiece carrier device having at least one workpiece carrier (2), with a shaft (20) surrounding a driving axis (4) and a rotary frame (3) mounted on a base frame (1) so as to be rotatable about the driving axis (4), and with workpiece holders (13) mounted on the rotary frame (3) so as to be rotatable about holding axes, wherein the at least one workpiece carrier (2) comprises a driving part (22) with a holder mounted so as to be rotatable about the driving axis (4), as well as a transmission part (26) operationally connected to the rotatably mounted workpiece holders (13), **characterised in that** an intermediate gear is attached to the rotatably mounted holder, the intermediate gear being operationally connected to the shaft (20) and the transmission part (26), respectively, in such a way that the transmission part (26) engages with the driving part (22) so as to be rotatable about an output point (29) that is spaced apart from the driving axis (4) by an eccentricity (E).

**2.** Workpiece carrier device according to claim 1, **characterised in that**, for the purpose of rotating the workpiece holders (13) with respect to the rotary frame (3), the transmission part (26) further engages with at least two workpiece holders (13) so as to be rotatable about a driving point that is spaced apart from the holder axis by the same eccentricity (E).

## Revendications

**1.** Dispositif porte-pièce comportant au moins un porte-pièce (2), avec un arbre (20) entourant une axe d'entraînement (4) et un bâti tournant (3) monté sur un bâti de base (1) de manière à pouvoir tourner autour de l'axe d'entraînement (4), et avec des supports de pièce (13) montés sur le bâti tournant (3) de manière à pouvoir tourner autour des axes de support, le au moins un porte-pièce (2) comprenant une pièce d'entraînement (22) avec une fixation pouvant tourner autour de l'axe d'entraînement (4) ainsi qu'une pièce de transmission (26) en liaison opérationnelle avec les supports de pièce (13) montés de manière à pouvoir tourner, **caractérisé en ce qu'**un engrenage intermédiaire est attaché sur la fixation montée de manière à pouvoir tourner, l'engrenage étant respectivement en liaison opérationnelle avec l'arbre (20) et la pièce de transmission (26) de telle sorte que la pièce de transmission (26) est en prise avec la pièce d'entraînement (22) de manière à pouvoir tourner autour d'un point de sortie (29) éloigné de l'axe d'entraînement (4) d'une excentricité (E).

**2.** Dispositif porte-pièce selon la revendication 1, **caractérisé en ce que** la pièce de transmission (26), en vue de la rotation des supports de pièce (13) vis-à-vis du bâti tournant (3), est de plus en prise avec au moins deux porte-pièces (13) de manière de pouvoir tourner autour d'un point d'entraînement éloigné de l'axe de support de la même excentricité (E).

Fig. 1

Fig.2

Fig.3

Fig. 4

EP 2 336 387 B1

Fig. 5

9

**IN DER BESCHREIBUNG AUFGEFÜHRTE DOKUMENTE**

**In der Beschreibung aufgeführte Patentdokumente**

- WO 2007025397 A1
- EP 1153155 A1
- DE 19803278 A1
- DE 10308471 A1